**Europäisches Patentamt**

**European Patent Office**

**Office européen des brevets**

(11) Veröffentlichungsnummer: **0 208 984**
**B1**

(12) **EUROPÄISCHE PATENTSCHRIFT**

(45) Veröffentlichungstag der Patentschrift:
23.05.90

(51) Int. Cl.⁵: **H03H 7/40**

(21) Anmeldenummer: **86108935.7**

(22) Anmeldetag: **01.07.86**

(54) Verfahren zur automatischen Impedanzanpassung eines Senders an eine Antenne.

(30) Priorität: **03.07.85 DE 3523823**

(43) Veröffentlichungstag der Anmeldung:
**21.01.87 Patentblatt 87/4**

(45) Bekanntmachung des Hinweises auf die Patenterteilung:
**23.05.90 Patentblatt 90/21**

(84) Benannte Vertragsstaaten:
**AT BE CH DE FR GB IT LI LU NL**

(56) Entgegenhaltungen:
**EP-A- 0 005 592**
**FR-A- 2 205 252**
**US-A- 3 778 731**
**US-A- 3 995 237**

(73) Patentinhaber: **Siemens Aktiengesellschaft,
Wittelsbacherplatz 2, D-8000 München 2(DE)**

(72) Erfinder: **Fünfgelder, Helmut, Dipl.-Ing. (FH),
Goethestrasse 28, D-8704 Uffenheim(DE)**
Erfinder: **Bässler, Erwin, Dipl.-Ing. (FH),
Nördlingerstrasse 61, D-8901 Königsbrunn(DE)**

## Beschreibung

### Technisches Gebiet

Die Erfindung bezieht sich auf ein Verfahren zum automatischen Anpassen der unbekannten Impedanz einer Antenne an die bekannte Nennimpedanz eines Senders unter Verwendung eines Anpaßnetzwerkes mit veränderlicher Impedanz, das eingangsseitig über einen Meßkopf an den Senderausgang und ausgangsseitig an die Antenne angeschaltet ist, das ferner wenigstens einen eingangsseitigen Kondensatorquerzweig mit einer veränderbaren Kapazität, beispielsweise aus mehreren einander parallel schaltbaren Kondensatorelementen und einen Spulenlängszweig mit einer veränderbaren Induktivität, beispielsweise aus mehreren einander in Serie schaltbaren Spulenelementen aufweist, das außerdem zum Einstellen seiner veränderlichen Impedanz durch Ändern der Kapazität des Kondensatorquerzweiges und/oder der Induktivität im Spulenlängszweig mit einem Mikroprozessor zusammenarbeitet, der abhängig von den ihm eingangsseitig vom Meßkopf übermittelten Informationen, insbesondere bezüglich des Spannungs-Stehwellenverhältnisses (VSWR) und der Phasenbeziehung die Impedanzeinstellung des Anpaßnetzwerkes im gewünschten Sinne steuert.

### Stand der Technik

Verfahren dieser Art sind beispielsweise durch die Literaturstelle EP O OO5 592 B1 bekannt. Abgesehen davon, daß die Abstimmprozedur hier in der Regel eine relativ große Anzahl von Einzelschritten mit sich bringt und die Anpaßgenauigkeit, bezogen auf das Smith-Diagramm, nur innerhalb eines Spannungs-Stehwellenverhältnisses VSWR = 2 erreicht wird, ist dieses Abstimmverfahren auch nicht für die Anpassung kurzer Antennen an einen Sender geeignet. Das hat insbesondere darin seinen Grund, daß die Fußpunktimpedanz einer kurzen Antenne nur eine sehr geringe Kapazität aufweist und das Parallelschalten von Kondensatorelementen auf der Ausgangsseite des Anpaßnetzwerkes zur Antenne hin den Antennenwirkungsgrad im allgemeinen nur verschlechtern kann. Werden höhere Anpaßgenauigkeiten verlangt, und zwar VSWR = 1,5, dann treten zusätzlich besondere Schwierigkeiten im Hinblick auf Fehlanpassungen auf, weil in die Messung bekanntlich die Toleranzen des die Steuerinformationen an den Mikroprozessor liefernden Meßkopfes eingehen und auch das verwendete Anpassungsnetzwerk aufgrund der unvermeidlichen Streureaktanzen keine idealen Netzwerkseigenschaften aufweist.

Bei dem durch die Literaturstelle FR-A-2 205 252 bekannten Antennenanpaßgerät, dessen Anpaßnetzwerk von einer Schaltungsstruktur Gebrauch macht, bei der auf der Antennenanschlußseite ein induktiver, in seiner Impedanz veränderbarer Querzweig vorgesehen ist, benötigt die Abstimmprozedur in der Regel ebenfalls eine relativ große Anzahl von Einzelschritten. Um hier in allen Fällen eine ausreichend genaue Anpassung erzielen zu können, müssen verschiedene Möglichkeiten durchgespielt werden. Zunächst wird die Impedanz des Senders entweder zum "G = 1"-Kreis oder zum "R = 1"-Kreis transformiert. Je Kreis gibt es dafür zwei Schnittpunkte mit der Annäherungsbahn der transformierten Sendeimpedanz. Von welchem Schnittpunkt aus die weitere Impedanztransformation längs des "G = 1"-Kreises bzw. des "R = 1"-Kreises zum besseren Abstimmergebnis führt, muß ausprobiert werden. Wird zugunsten einer schnelleren Abstimmprozedur willkürlich nur einer von den beiden möglichen Schnittpunkten auf dem "G = 1"-Kreis bzw. dem "R = 1"-Kreis für die durchzuführende Impedanztransformation berücksichtigt, so müssen im allgemeinen Spannungs-Stehwellenverhältnisse VSWR = 2 in Kauf genommen werden.

### Offenbarung der Erfindung

Der Erfindung liegt die Aufgabe zugrunde, für ein Verfahren der einleitend beschriebenen Art eine weitere Lösung anzugeben, die bei höherer Anpaßgenauigkeit in der Größenordnung VSWR = 1,5 eine schnelle, Fehlanpassungen weitestgehend vermeidende Anpassung der Antennenimpedanz an die Senderimpedanz zuläßt.

Diese Aufgabe wird gemäß der Erfindung durch die im Patentanspruch 1 angegebenen Merkmale gelöst.

Der Erfindung liegt die wesentliche Erkenntnis zugrunde, daß die durch Toleranzen der Meßkopfschaltung einerseits und Streureaktanzen des Anpaßnetzwerkes andererseits bedingten Fehlanpassungen dadurch weitestgehend unterbunden werden können, daß, bezogen auf das Smith-Diagramm als weiteres Kriterium für die Einstellung des Anpaßnetzwerkes das Kriterium "G = 1" Kreis in der Weise herangezogen wird, daß die über das Anpaßnetzwerk zu transformierende Impedanz der Antenne zunächst in den induktiven Bereich bis zum "G = 1" Kreis und anschließend von hier aus längs des "G = 1" Kreises solange verschoben wird, bis der Wechsel vom induktiven in den kapazitiven Bereich angezeigt wird. Droht in diesem Falle eine Fehlanpassung, so kann dies in einfacher Weise dadurch korrigiert werden, daß im Zuge der Durchführung des zweiten Abstimmschrittes ein Zwischenschritt veranlaßt wird, indem nochmals eine Annäherung der transformierten Impedanz der Antenne an den "G = 1" Kreis vorgenommen wird. Wie umfangreiche Untersuchungen ergeben haben, ist dieser Zwischenschritt dann angezeigt, wenn bei der Annäherung der transformierten Impedanz der Antenne an den "G = 1" Kreis im ersten Abstimmschritt ein VSWR > 3 auftritt.

Bei Abstimmgrenzsituationen, in denen ein solcher Standard-Abstimmablauf versagt, muß zunächst durch eine Vortransformation der zu transformierenden Impedanz der Antenne dafür gesorgt werden, daß ein solcher Standard-Abstimmablauf durchgeführt werden kann. Erreichen läßt sich dies in einfacher Weise entsprechend den im Patentanspruch 2 angegebenen Merkmalen.

Kurze Beschreibung der Zeichnung

In der Zeichnung bedeuten die der näheren Erläuterung der Erfindung dienenden Figuren

Fig. 1 das Blockschaltbild eines mikroprozessorgesteuerten Anpaßnetzwerkes,
Fig. 2 das Flußdiagramm für einen Standard-Abstimmvorgang,
Fig. 3 die Erläuterung eines ersten Standard-Abstimmvorgangs anhand eines Smith-Diagramms,
Fig. 4 die Erläuterung eines zweiten Standard-Abstimmvorgangs anhand eines Smith-Diagramms,
Fig. 5 ein weiteres Smith-Diagramm zur Erläuterung der Grenzen, in denen ein Standard-Abstimmvorgang durchführbar ist,
Fig. 6 ein weiteres Flußdiagramm für mögliche Abstimmabläufe unter Berücksichtigung evtl. erforderlicher Vortransformationen der Antennenimpedanz.

Bester Weg zur Ausführung der Erfindung

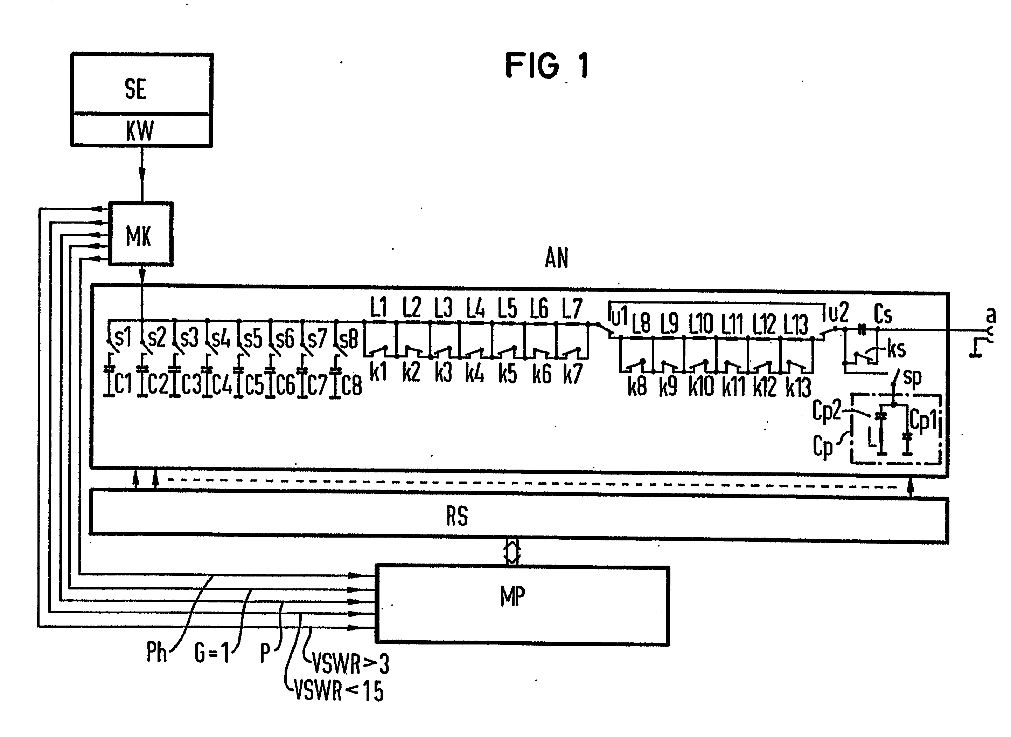

Das Blockschaltbild nach Fig. 1 zeigt einen Sender SE mit Kanalwähler KW, der ausgangsseitig über den Meßkopf MK mit der Eingangsseite des Anpaßnetzwerkes AN verbunden ist. Da Anpaßnetzwerk AN weist einen Ausgang a auf, an den die Antenne angeschaltet wird, deren Impedanz über das Anpaßnetzwerk AN transformiert an die Nennimpedanz des Senders SE anzupassen ist. Das Anpaßnetzwerk AN weist auf seiner Eingangsseite einen Kondensatorquerweig auf, der acht Kondensatorelemente C1, C2,...C8 aufweist, die über den einzelnen Kondensatorelementen zugeordnete Schalter S1, S2,...S8 einander parallel schaltbar sind. Der Spulenlängszweig des Anpaßnetzwerkes AN weist in Serie geschaltete Spulenelemente L1, L2,...L13 auf, die über ihnen zugeordnete Schalter k1, k2, ... k13 kurzschließbar sind. Die Serienschaltung der Spulenelemente L8, L9, ... L13 kann auch über die ebenfalls im Längszweig vorgesehenen Umschalter U1 und U2 im Sinne eines Kurzschlusses überbrückt werden. Auf seiten des Ausgangs a weist das Anpaßnetzwerk AN noch einen über den Schalter ks kurzschließbaren Serienkondensator Cs sowie einen aus der Serienschaltung des Parallelkondensators Cp und dem Schalter sp bestehenden Kondensatorquerweig auf. Der Parallelkondensator Cp besteht hierbei aus dem Kondensatorelement Cp1, dem die Reihenschaltung aus dem Kondensatorelement Cp2 und der Induktivität L parallel geschaltet ist. Diese Kombination wirkt wie ein Kondensator, dessen Größe mit zunehmender Arbeitsfrequenz des Senders abnimmt.

Mit Rücksicht auf die im allgemeinen hohe Ausgangsleistung des Senders SE sind die Schalter s1, s2, ... s8, sp sowie k1, k2, ... k13, und ks Relaiskontakte, deren zugehörige Relais mit einer die nötigen Steuerströme liefernden Relaissteuerung RS verbunden sind. Die Relaissteuerung RS selbst wird vom Mikroprozessor MP angesteuert, dem von den fünf Ausgängen des Meßkopfes MK eingangsseitig die für das Einstellen des Anpaßnetzwerkes AN nötigen Informationen über die Phase Ph, den Sendepegel P, das Spannungs-Stehwellenverhältnis VSWR < 1,5 und VSWR > 3 sowie das Kriterium "G = 1" zugeführt werden. Das Kriterium "G = 1" entspricht dabei dem "G = 1" Kreis im Smith-Diagramm.

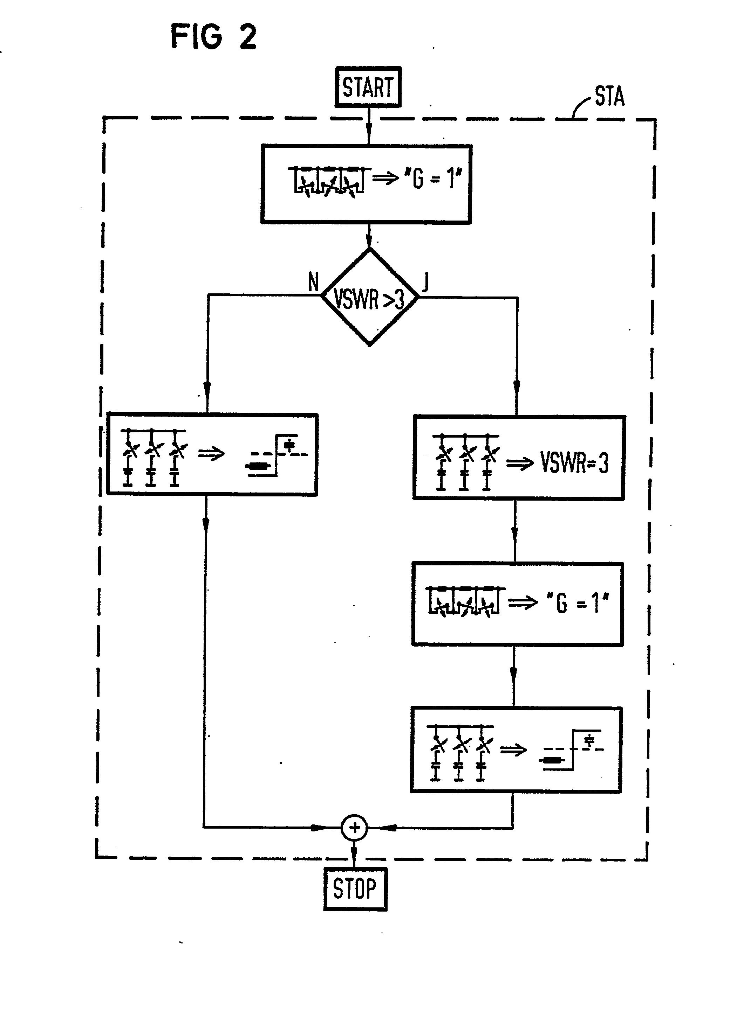

Eine mit dem Anpaßnetzwerk AN durchzuführende automatische Anpassung der unbekannten Impedanz der am Ausgang a angeschlossenen Antenne an die Nennimpedanz des Senders SE zeigt das Flußdiagramm nach Fig. 2.

Der eigentliche Standard-Abstimmvorgang ist mit STA bezeichnet. Bei "START" erfolgt in einem ersten Schritt durch Schalten der Spulenelemente L1, L2, ... L13 im Spulenlängszweig eine Annäherung der transformierten Impedanz der Antenne an den "G = 1" Kreis im Smith-Diagramm und zwar im induktiven Bereich. Nunmehr wird geprüft, ob VSWR > 3 ist. Ist das Prüfungsergebnis negativ (N), dann wird in einem zweiten Abstimmschritt durch Schalten der Kondensatorelemente C1, C2, ... C8 im eingangsseitigen Kondensatorquerweig die transformierte Impedanz der Antenne solange längs des "G = 1" Kreises verschoben, bis der Meßkopf MK dem Mikroprozessor MP den Übergang vom induktiven Bereich in den kapazitiven Bereich signalisiert. Damit ist dann der Standard-Abstimmvorgang beendet, was im Flußdiagramm nach Fig. 2 durch das "STOP"-Symbol angezeigt ist.

Ist das Ergebnis der Prüfung VSWR > 3 positiv (J), dann kommt ebenfalls der bereits beschriebene zweite Abstimmschritt zustande, bei dem die Kondensatorelemente im eingangsseitigen Querzweig geschaltet werden. Der Ablauf dieses zweiten Abstimmschrittes wird jedoch durch einen Zwischenschritt unterbrochen, sobald VSWR = 3 erreicht ist. Der Zwischenschritt besteht darin, daß nunmehr wiederum durch Schalten der Spulenelemente L1, L2, ... L13 eine Korrektur der transformierten Impedanz der Antenne in Richtung auf den "G = 1" Kreis vorgenommen wird. Anschließend wird durch weiteres Schalten der Kondensatorelemente im eingangsseitigen Querzweig der zweite Abstimmschritt bis zum Übergang der transformierten Impedanz der Antenne vom induktiven in den kapazitiven Bereich zu Ende geführt.

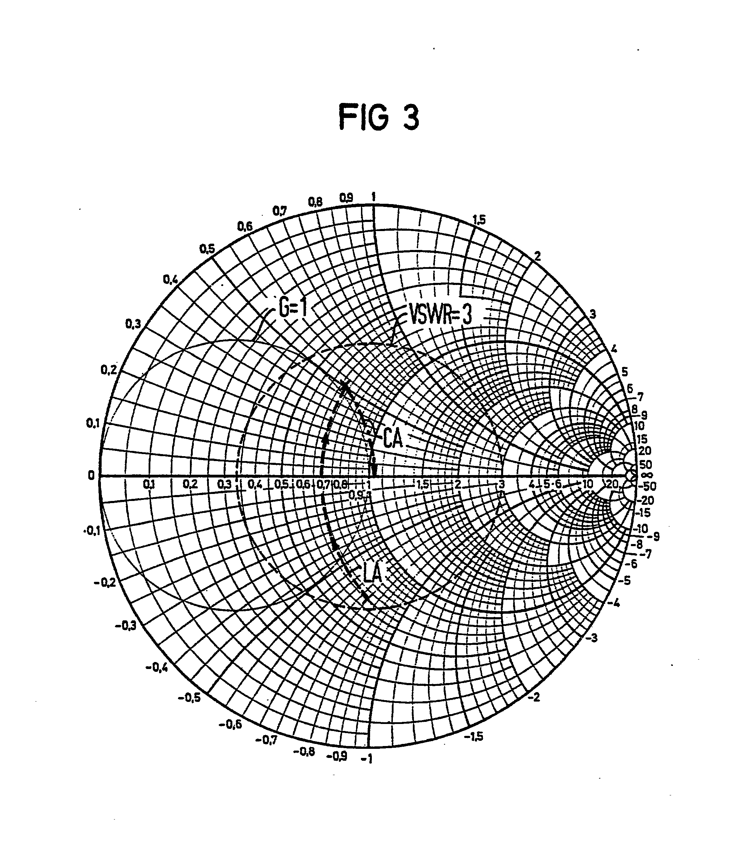

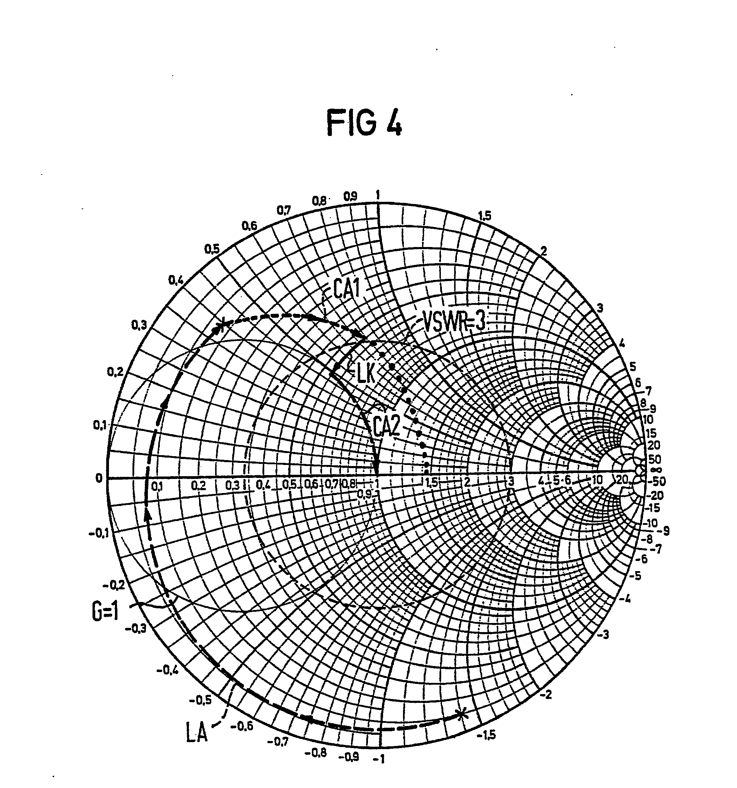

Zur weiteren Veranschaulichung dieses Standard-Abstimmvorganges sind in den Figuren 3 und 4 noch zwei Smith-Diagramme gezeigt, in die der Abstimmablauf ebenfalls eingezeichnet ist. Das Smith-Diagramm nach Fig. 3 zeigt dabei den Standard-Abstimmvorgang STA für den Fall, daß die transformierte Impedanz der Antenne stets innerhalb des "VSWR = 3" Kreises liegt. Zu Beginn des Abstimmvorgangs befindet sich die durch ein Kreuz dargestellte transformierte Impedanz der Antenne im kapazitiven Bereich und wird nunmehr durch Einschalten von Spulenelementen entsprechend der Bahn LA in den induktiven Bereich bis zum "G = 1" Kreis verschoben. Die transformierte Impedanz der Antenne ist an dieser Stelle ebenfalls wieder durch ein Kreuz dargestellt. Da die Lage der transformierten Impedanz der Antenne innerhalb des Kreises VSWR = 3 liegt, erfolgt nunmehr die Abstimmung im zweiten Abstimmschritt ausschließlich durch Schalten der Kondensatorelemente im eingangsseitigen Querzweig des Anpaßnetzwerks AN längs der Verschiebelinie CA, bis in unmittelbarer Nähe des "Eins"-Punktes auf der reellen Achse des Smith-Diagramms, womit dann der Abstimmvorgang beendet ist.

Das Smith-Diagramm nach Fig. 4 zeigt einen Standard-Abstimmvorgang STA, bei dem der zweite Abstimmschritt in der im Zusammenhang mit Fig. 2 beschriebenen Weise modifiziert ist. Die wiederum durch ein Kreuz angegebene transformierte Impedanz der Antenne liegt zu Beginn des Abstimmvorgangs hier ebenfalls im kapazitiven Bereich des Smith-Diagramms, jedoch außerhalb des Kreises "VSWR = 3" Kreises. Zunächst erfolgt durch Schalten der Spulenelemente wiederum eine Verschiebung der transformierten Impedanz der Antenne längs der Linie LA, bis der "G = 1" Kreis erreicht ist. Nunmehr wird aber der zweite Abstimmschritt durch Schalten der Kondensatorelemente im eingangsseitigen Querzweig längs der Linie CA1 lediglich solange durchgeführt, bis der "VSWR = 3" Kreis erreicht ist. Dann setzt der Zwischenschritt ein, indem die transformierte Impedanz der Antenne längs der Linie Lk durch Schalten von Spulenelementen zunächst an den "G = 1" Kreis wieder angenähert wird, um dann den durch diesen Zwischenschritt unterbrochenen zweiten Abstimmschritt weiter durchzuführen, bis die transformierte Impedanz der Antenne längs der Linie CA2 die reelle Achse des Smith-Diagramms erreicht hat, was dem Mikroprozessor vom Meßkopf MK durch den Übergang vom induktiven in den kapazitiven Bereich angezeigt wird. Ohne den Zwischenschritt würde der Abgleich längs der Linie CA3 erfolgen, wobei zwar bei diesem Ausführungsbeispiel noch die Abstimmgenauigkeit R < 1,5 gerade erreicht würde, was jedoch in der Praxis durch die unvermeidliche relativ große Meßtoleranz doch bereits mit Sicherheit nicht mehr gewährleistet wäre.

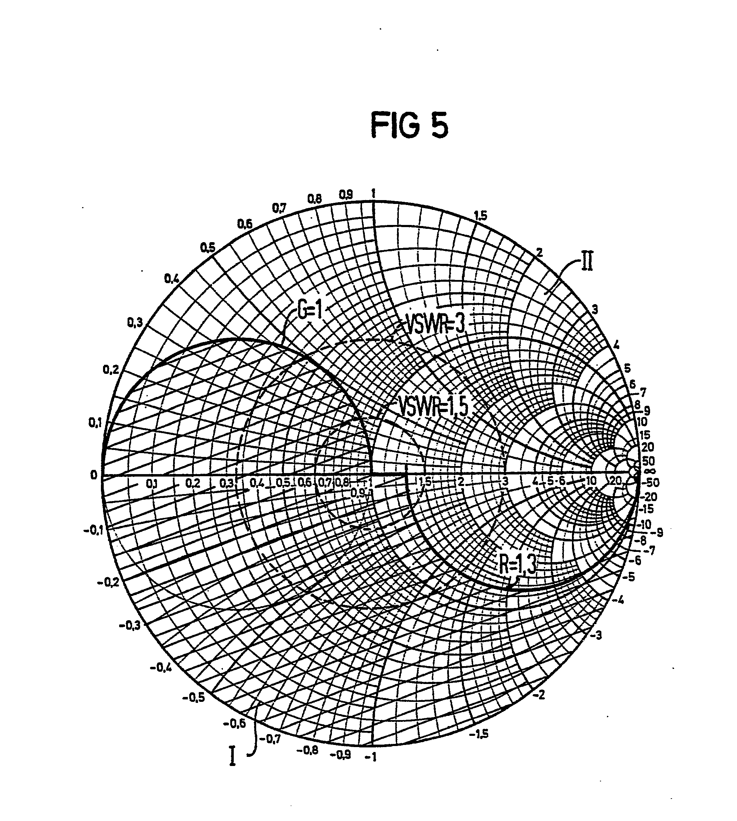

Das weitere in Fig. 5 dargestellte Smith-Diagramm verdeutlicht den Bereich, in dem die anzupassende Antennenimpedanz im Smith-Diagramm liegen muß, wenn der anhand der Fig. 2 dargestellte Standard-Abstimmvorgang mit Erfolg durchgeführt werden können soll. Dieser schraffierte Bereich I ist bestimmt durch den induktiven Bereich innerhalb des "G = 1" Kreises und den kapazitiven Bereich unter Ausschluß des vom "R = 1,3" Kreis eingeschlossenen kapazitiven Teilbereiches. Liegt die anzupassende Impedanz der Antenne nicht im schraffierten Bereich I, sondern im Bereich II, der die restliche Fläche des Smith-Diagramms ausmacht, dann muß zunächst eine Vortransformation vorgenommen werden, die die Impedanz der Antenne zunächst einmal in den Bereich I transformiert. Hierzu dienen die auf der Antennenseite des Anpaßnetzwerkes AN vorgesehenen Kondensatoren, nämlich der Serienkondensator Cs und der Parallelkondensator Cp.

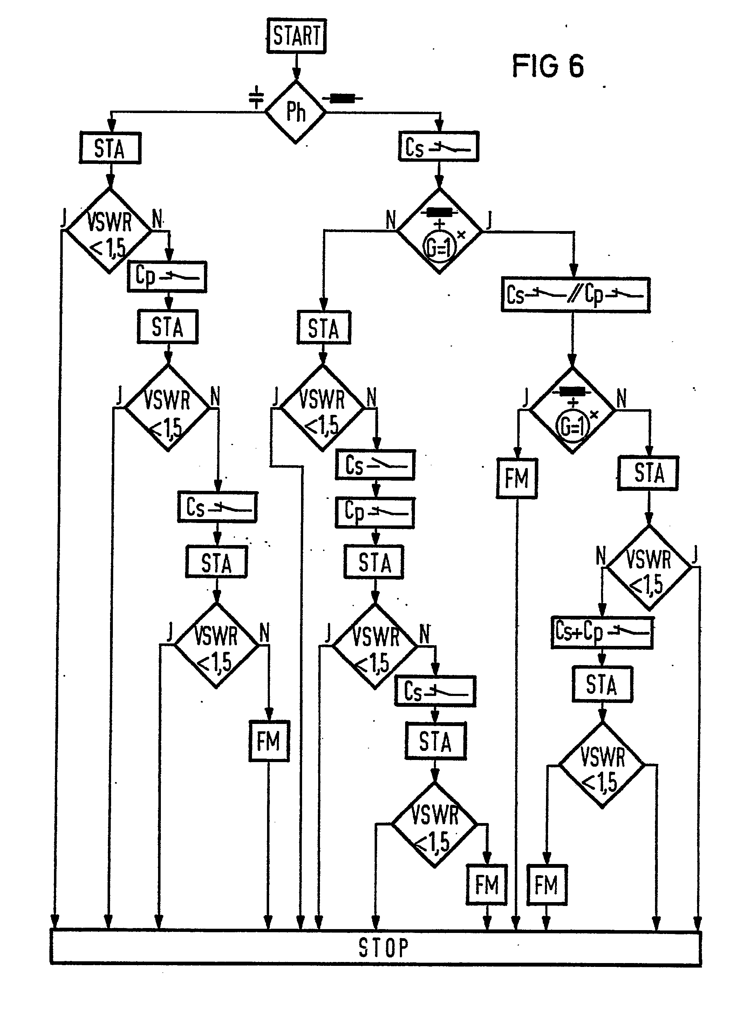

Die im Zusammenhang mit notwendigen Vortransformationen gegebenen Möglichkeiten für die Durchführung eines Abstimmvorgangs sind im Flußdiagramm nach Fig. 6 dargestellt. Mit dem "START" eines Abstimmvorgangs wird zunächst über die Phase Ph geprüft, ob die anzupassende Impedanz der Antenne im kapazitiven oder im induktiven Bereich liegt.

Liegt die Impedanz der Antenne im kapazitiven Bereich des Smith-Diagrammes, findet ein Standard-Abstimmvorgang STA statt, an dessen Ende geprüft wird, ob VSWR < 1,5 erreicht worden ist. Der "VSWR = 1,5" Kreis ist in das Smith-Diagramm nach Fig. 5 ebenfalls eingetragen. Ist dies Der Fall (J), dann ist der Abstimmvorgang beendet, was auch in diesem Flußdiagramm durch das Symbol "STOP" verdeutlicht ist. Ist VSWR < 1,5 nicht erreicht worden (N), wird zunächst der Parallelkondensator Cp eingeschaltet und anschließend ein Standard-Abstimmvorgang STA durchgeführt. Auch hier ist der Abstimmvorgang beendet, wenn VSWR < 1,5 erreicht worden ist. Ist jedoch VSWR < 1,5 nicht erreicht worden (N), dann wird zusätzlich noch der Serienkondensator Cs eingeschaltet und anschließend wiederum der Standard-Abstimmvorgang STA durchgeführt. Ergibt sich auch hier am Ende dieses Standard-Abstimmvorgangs STA VSWR < 1,5, dann wird der Abstimmvorgang mit einer Fehlermeldung FM beendet.

Ergibt die Phase Ph nach dem "START" eines Abstimmvorgangs, daß die anzupassende Impedanz der Antenne im induktiven Bereich liegt, dann wird zunächst der Serienkondensator Cs eingeschaltet und anschließend geprüft, ob die transformierte Impedanz der Antenne sowohl im induktiven Bereich als auch außerhalb des "G = 1" Kreises liegt. Ist nur eine dieser beiden Bedingungen oder keine dieser beiden Bedingungen erfüllt (N), wird ein Standard-Abstimmvorgang STA durchgeführt und dann geprüft, ob VSWR < 1,5 ist. Ist dies der Fall (J), ist der Abstimmvorgang beendet. Ist dies nicht der Fall (N), dann wird der Serienkondensator Cs abgeschaltet und der Parallelkondensator Cp angeschaltet und anschließend der Standard-Abstimmvorgang STA durchgeführt. Ist dann die Abstimmbedingung VSWR < 1,5 nicht erfüllt (N), wird zusätzlich zum Parallelkondensator Cp auch der Serienkondensator Cs eingeschaltet und der Standard-Abstimmvorgang STA wiederholt. Ist auch jetzt die Abstimmbedingung noch nicht erfüllt, dann wird der Abstimmvorgang mit der Fehlermeldung FM beendet.

Ist die Doppelbedingung, Lage der transformierten Impedanz der Antenne im induktiven Bereich und außerhalb des "G = 1" Kreises erfüllt (J), dann wird, wie der rechte Teil des Flußdiagramms zeigt, der Serienkondensator Cs wieder abgeschaltet und dafür der Parallelkondensator Cp eingeschaltet. Nun wird erneut die Doppelbedingung geprüft und sofern sie erfüllt ist (J), der Abstimmvorgang mit der Fehlermeldung FM beendet. Ist eine der beiden Bedingungen oder keine der beiden Bedingungen der Doppelbedingung erfüllt (N), dann wird der Standard-Abstimmvorgang STA durchgeführt und anschließend wiederum geprüft, ob VSWR < 1,5 ist. Ist die Abstimmbedingung erfüllt (J), ist der Abstimmvorgang beendet, im anderen Fall (N) wird zusätzlich zum Parallelkondensator Cp der Serienkondensator Cs nochmal eingeschaltet und anschließend der Standard-Abstimmvorgang STA durchgeführt. Ist nunmehr die Abstimmbedingung VSWR < 1,5 immer noch nicht erfüllt, dann wird der Abstimmvorgang mit der Fehlermeldung FM beendet.

## Gewerbliche Verwertbarkeit

Dem Verfahren nach der Erfindung kommt eine besondere Bedeutung in seiner Anwendung bei mobilen Funkgeräten zu, bei denen sich bekanntlich durch die ständige Veränderung der Umgebungssituation die Antennenimpedanz nicht nur in Abhängigkeit der verwendeten Arbeitsfrequenz des Senders, sondern auch in Abhängigkeit der Änderung der Antennenumgebung stark ändert und dementsprechend eine schnelle und genaue Anpassung in weitesten Grenzen Voraussetzung für einen störungsfreien Betrieb sind.

## Patentansprüche

1. Verfahren zum automatischen Anpassen der unbekannten Impedanz einer Antenne an die bekannte Nennimpedanz eines Senders unter Verwendung eines Anpaßnetzwerkes mit veränderlicher Impedanz, das eingangsseitig über einen Meßkopf an den Senderausgang und ausgangsseitig an die Antenne angeschaltet ist, das ferner wenigstens einen eingangsseitigen Kondensatorquerzweig mit einer veränderbaren Kapazität, beispielsweise aus mehreren einander parallel schaltbaren Kondensatorelementen und einen Spulenlängszweig mit einer veränderbaren Induktivität, beispielsweise aus mehreren einander in Serie schaltbaren Spulenelementen aufweist, das außerdem zum Einstellen seiner veränderlichen Impedanz durch Ändern der Kapazität des Kondensatorquerzweiges und/oder der Induktivität im Spulenlängszweig mit einem Mikroprozessor zusammenarbeitet, der abhängig von den ihm eingangsseitig vom Meßkopf übermittelten Informationen, insbesondere bezüglich des Spannungs-Stehwellenverhältnisses (VSWR) und der Phasenbeziehung, die Impedanzeinstellung des Anpassungsnetzwerkes im gewünschten Sinne steuert, **dadurch gekennzeichnet**, daß zur Durchführung eines Standard-Abstimmvorganges (STA) die an den Senderausgang über das Anpaßnetzwerk (AN) transformierte Impedanz der Antenne in einem ersten Schritt durch Ändern der Induktivität im Spulenlängszweig einen induktiven Wert annimmt und bezogen auf das Smith-Diagramm den "G = 1" Kreis erreicht, daß dann in einem zweiten Schritt durch Ändern der Kapazität im Kondensatorquerzweig die transformierte Impedanz der Antenne auf dem "G = 1" Kreis (G = 1) solange verschoben wird bis der Meßkopf (MK) den Übergang vom induktiven Bereich in den kapazitiven Bereich anzeigt und damit der Abstimmvorgang beendet wird, daß jedoch, sofern die transformierte Impedanz der Antenne bei Erreichen des "G = 1" Kreises ein zu großes Spannungs-Stehwellenverhältnis, ungefähr VSWR > 3, anzeigt, im Ablauf des zweiten Schrittes bei Erreichen eines vorgegebenen Spannungs-Stehwellenverhältnisses, ungefähr VSWR = 3, ein Zwischenschritt durchgeführt wird, bei dem durch weiteres Ändern der Induktivität im Spulenlängszweig die transformierte Impedanz der Antenne in Richtung ihrer Verschiebung bis zum "G = 1" Kreis korrigiert wird und daß für den Vollzug dieser Verfahrensschritte der Meßkopf schaltungsmäßig für die Abgabe von Steuerinformationen an den Mikroprozessor (MP) so ausgelegt ist, daß diese Steuerinformationen, neben Angaben über Sendepegel (P), Phase (Ph) und Spannungs-Schwellenverhältnisse (VSWR < 1,5; VSWR > 3) auch ein Kriterium für den "G = 1" Kreis (G = 1) aufweist.

2. Verfahren nach Anspruch 1, **dadurch gekennzeichnet**, daß bei einer Lage der anzupassenden Impedanz der Antenne, bezogen auf das Smith-Diagramm im induktiven Bereich außerhalb des "G = 1" Kreises oder im kapazitiven Bereich innerhalb des "R ≥ 1,5" Kreises vor Durchführung eines Standard-Abstimmvorganges (STA) eine Vortransformation der Impedanz der Antenne zum Senderausgang über das Anpaßnetzwerk (AN) durch Einschalten eines Serienkondensators (Cs) auf seiner Ausgangsseite im Längszweig und/oder eines Parallelkondensators (Cp) in einem durch diesen Kondensator gebildeten ausgangsseitigen Querzweig des Anpaßnetzwerkes herbeigeführt wird.

## Claims

1. A method for automatically matching the unknown impedance of an antenna to the known nominal impedance of a transmitter using a matching network having variable impedance and which is connected on the input side via a measuring head to the transmitter output and on the output side to the antenna, which network also has at least one input-side capacitive shunt arm with a variable capacitance, consisting for example of a plurality of capacitor elements which can be switched in parallel to one another and has an inductive series arm with a variable inductance consisting, for example, of a plurality of coil elements which can be switched in series to one another, which network in addition for setting its variable impedance by changing the capacitance of the capacitive shunt arm and/or the inductance in the inductive series arm cooperates with a micro-processor which controls, in dependence on the information transferred to it on the input side by the measuring head, in particular relating to the voltage standing wave ratio (VSWR) and the phase relation, the impedance setting of the matching network in the desired direction, characterized in that, to perform a standard tuning process (STA), the transformed antenna impedance presented to the transmitter output via the matching network (AN) assumes an inductive value in a first step by changing the inductance in the inductive series arm and, relative to the Smith diagram, reaches the "G = 1" circle, in that, in a second step, by changing the capacitance in the capacitive shunt arm the transformed antenna impedance is moved along the "G = 1" circle (G = 1) until the measuring head (MK) indicates the transition from the inductive zone to the capacitive zone and thus the tuning process is concluded in that, however, if the transformed antenna impedance indicates an excessively high voltage standing wave ratio, approximately VSWR > 3 when the "G = 1" circle is reached, an intermediate step is performed in the course of the second step when a predetermined voltage standing wave ratio, approximately VSWR= 3, is reached, in which second step the transformed impedance of the antenna is corrected, by further changing the inductance in the inductive series arm, in the direction of its displacement to the "G = 1" circle and in that for the completion of these process steps, the measuring head is designed in terms of circuitry to issue control information to the micro-processor (MP) in such a way that these items of control information have, in addition to information relating to the transmitting level (P), Phase (Ph) and voltage threshold ratios (VSWR) < 1.5; VSWR > 3), also a criterion for the "G = 1" circle (G = 1).

2. Method according to Claim 1, characterized in that when the antenna impedance to be matched is located, relative to the Smith diagram, in the inductive zone outside the "G = 1" circle or in the capacitive zone inside the "R ≥ 1.5" circle prior to the execution of a standard tuning process (STA) a preliminary transformation of the antenna impedance to the transmitter output via the matching network (AN) is performed by connecting a series capacitor (Cs) on the output side of the series arm and/or by connecting a parallel capacitor (Cp) in an output-side shunt arm, formed by this capacitor, of the matching network.

**Revendications**

1. Procédé d'adaptation automatique de l'impédance inconnue d'une antenne à l'impédance nominale connue d'un émetteur, moyennant l'utilisation d'un réseau d'adaptation possédant une impédance variable, qui est raccordé, côté entrée, par l'intermédiaire d'une tête de mesure à la sortie de l'émetteur et, côté sortie, à l'antenne et possède en outre au moins une branche transversale située sur la côté entrée et contenant un condensateur possédant une capacité variable et constitué par exemple par plusieurs éléments de condensateur pouvant être branchés en parallèle, et une branche longitudinale contenant une bobine possédant une inductance variable et constituée par exemple par plusieurs éléments de bonbine branchés en série, et qui coopère, en outre, pour le réglage de son impédance variable, au moyen d'une modification de la capacité de la branche transversale contenant le condensateur et/ou au moyen de l'inductance contenue dans la branche longitudinale contenant la bobine, avec un microprocesseur qui commande dans le sens désiré le réglage de l'impédance du réseau d'adaptation, en fonction des informations, qui sont transmises à son entrée par la tête de mesure, notamment le taux d'ondes de tension stationnaires (VSWR) et la relation de phase, caractérisé par le fait que, pour l'exécution d'une opération du réglage de l'accord standard (STA), l'impédance de l'antenne, transformée sur la sortie de l'émetteur par l'intermédiaire du réseau d'adaptation (AN), prend une valeur inductive lors d'un premier pas, par suite de la modification d'inductance présente dans la branche longitudinale contenant la bobine, et atteint, en rapport avec le diagramme de Smith, le cercle "G = 1", qu'ensuite, lors d'un second pas, l'impédance transformée de l'antenne est transférée, par modification de la capacité située dans la branche transversale contenant le condensateur, sur le cercle "G = 1" (G = 1) jusqu'à ce que la tête de mesure (MK) indique le passage depuis la zone inductive dans la zone capacitive et arrête de ce fait l'opération du réglage de l'accord, mais que, dans la mesure où l'impédance transformée de l'antenne indique un taux d'ondes de tension stationnaires trop élevé, avoisinant VSWR > 3, lorsque le cercle "G = 1" est atteint, un pas intermédiaire est exécuté lors du déroulement du second pas, lorsqu'est atteint un taux d'ondes de tension stationnaires prédéterminé, avoisinant VSWR = 3, pas intermédiaire lors duquel l'impédance transformée de l'antenne est corrigée, au moyen d'une modification supplémentaire de l'inductance présente dans la branche longitudinale contenant la bobine, dans le sens d'un décalage jusqu'au cercle "G = 1", et que pour compléter ces pas opératoires, le circuit de la tête de mesure est agencé, pour la délivrance d'informations de commande au microprocesseur (MP), de manière que ces informations de commande contiennent, outre des indications concernant le niveau d'émission (P), la phase (Ph) et des taux d'ondes de tension stationnaires (VSWR < 1,5; VSWR > 3), également un critère pour le cercle "G = 1" (G = 1).

2. Procédé suivant la revendication 1, caractérisé par le fait que pour une valeur de l'impédance, qui doit être adaptée, de l'antenne, rapportée au diagramme de Smith dans la zone inductive à l'extérieur du cercle "G = 1" ou dans la zone capacitive à l'intérieur du cercle "R ≥ 1,5", avant l'exécution d'une opération du réglage de l'accord standard (STA), une transformation préalable de l'impédance de l'antenne en direction de la sortie de l'émetteur est exécutée par l'intermédiaire du réseau d'adaptation (AN) au moyen du branchement d'un condensateur série (Cs) situé sur le côté sortie dans la branche longitudinale et/ou d'un condensateur parallèle (Cp) dans une branche transversale du réseau d'adaptation, située du côté sortie et formée par ce condensateur.

# FIG 1

EP 0 208 984 B1

FIG 2

# FIG 3

# FIG 4

# FIG 5

FIG 6